Europäisches Patentamt

European Patent Office

Office européen des brevets

(19)

(11) Publication number : **0 474 435 A2**

# (12) EUROPEAN PATENT APPLICATION

(21) Application number : **91307939.8**

(22) Date of filing : **30.08.91**

(51) Int. Cl.$^5$ : **G09G 1/16**

(30) Priority : **31.08.90 US 575729**

(43) Date of publication of application :
**11.03.92 Bulletin 92/11**

(84) Designated Contracting States :
**DE FR GB IT NL**

(71) Applicant : **TEXAS INSTRUMENTS
INCORPORATED
13500 North Central Expressway
Dallas Texas 75265 (US)**

(72) Inventor : **Balistreri, Anthony M.
4944 Woodway, Apt. No. 23
Houston, Texas 77056 (US)**
Inventor : **Guillemaud, Andre J.
3819 Stovepipe
Sugarland, Texas 77479 (US)**

(74) Representative : **Nettleton, John Victor et al
Abel & Imray Northumberland House 303-306
High Holborn
London, WC1V 7LH (GB)**

(54) **A graphics display system with a video random access memory having a one-half row length register for serial access to the memory.**

(57) A graphics display system includes a data processor and a video source (99) that generate data representing an image, memory addresses for storing the data, and control signals for the system. A memory (105) includes an array of memory cells arranged in rows and N columns with each memory cell being assigned a row and a column address. A data register (107) which interconnects with the data processor, the video source, and the array of memory cells has N/2 storage elements. The data register (107) responds to the control signals and to a serial sequence of data received from the video source (99) for storing the sequence of data. Subsequently in response to memory addresses and further control signals that data is written in parallel to an addressed row and selectively to memory cells within either a low-half of the column addresses or a high-half of the column addresses. The graphics display system is further arranged for reading the data from the array of memory cells in parallel to the data register which sends that data in serial sequence for conversion to a video signal to produce the desired image on a display device.

FIG. 3

EP 0 474 435 A2

## RELATED CASES

This application contains subject matter disclosed in copending applications Serial No. 387,569 (TI-14315), filed 28 July 1989, Serial No.          (TI-14755),      filed                  , Serial No.                    (TI-15211), filed          , Serial No.             (TI-14254),   filed                  , and  in  U.S. Patent Nos. 4,281,401, 4,639,890, and 4,747,081. The above mentioned applications and patents are incorporated herein by reference.

## BACKGROUND OF THE INVENTION

### Field of the Invention

This invention relates to a graphics display and image processing system and more particularly to a graphics display and image processing system including a video random access memory having a register for serial access to the memory.

### Description of Related Art

In a graphics display system, a data processor and/or an image processor generates data representing a desired image for the likes of a video display or a plotter. The data from the processor is written into a memory that includes an array of dynamic memory cells arranged in rows and columns. There are row lines and column lines which select the individual cells in response to addresses for writing into the memory cells and reading from the memory cells. The row and column lines are identified and accessed by addresses which are applied to row and column selection circuits of the memory by the processor. A row address enables the processor to access a row of the array of memory cells. A column address likewise enables the processor to access a column of the array of memory cells. For random access to a single selected memory cell, both row and column addresses are applied to the row and column selection circuits of the memory. Data is written into or read from the selected memory cell by way of a bit line. For a parallel write or read operation, a selected row address and the signal to access all columns of the array are applied to the memory. Data is written into or read from all of the memory cells of the selected row. Each of those memory cells of the selected row transfers the data by way of a separate bit line, each of which is associated with a different column of the memory cells.

Associated with the array of memory cells, there is a data register that has as many storage elements as there are memory cells in each row of the memory array, i.e., the data register has a different storage element associated with each column of memory cells in the memory array. This data register is a facility for receiving a serial sequence of data produced by the video source and for temporarily storing that data. Subsequently that stored data is transferred from the data register in parallel and is written in parallel into all of the memory cells of the selected row of the memory array. Such a write operation is referred to as a serial write operation. The data register also is a facility for receiving data read from the memory cells of any selected row of the memory array. Such data, read out of the memory array, is transferred in parallel to the data register where it is stored temporarily. Thereafter the data is sent in serial sequence from the data register to a display device. This readout operation is referred to as a serial read operation.

The display device may be any apparatus which receives the serial sequence of data from the data register and formulates that data into the desired image for viewing by a person.

It is known to divide the column addresses of the memory array into high-half addresses and low-half addresses for the purpose of facilitating read operations. Also it is known to likewise split the data register into halves, each half of which is associated with either the high-half or the low-half addresses of the memory array. By so splitting the memory array and the data register into high and low halves, it is possible to design a graphics display system so that serial data read out from the memory array can be converted to video signals without producing any flicker in the image when it is presented by the display device.

The design of a graphic display system is dependent upon many factors including the number and cost of integrated circuit chips, the complexity and cost of laying out and interconnecting those chips, and the cost of software for controlling the system. There always is pressure to select the lowest cost semiconductor chips which will perform the necessary functions. As a result, there is ongoing pressure on the semiconductor industry to design and produce new varieties of semiconductor chips which will perform the same or similar functions for a lower cost. In general the cost of a semiconductor chip varies with the area of the chip.

In order to reduce chip area without using a reduced dimension technology, some circuitry currently used on the chips must be eliminated or replaced by other simpler circuitry. However, eliminating circuitry which has been considered essential to the operation of prior art systems presents a substantial problem.

In reviewing the use of area on a video random access memory semiconductor chip, we noticed that arrays of memory cells occupy a predominate amount of the chip area. Generally the arrays of memory cells are needed in their entirety and cannot be eliminated in any part. Another substantial portion of the memory chip area is occupied by the data register which is used for serial access to the memory. The problem is to reduce the memory chip area occupied by the data register without increasing the complexity of the design, the operation of the video random access memory chip, or the operation of the whole graphics display system.

## Summary of the Invention

This problem and other problems are solved by a graphics display system including a data processor that generates data representing an image, memory addresses for storing the data, and control signals for the system. A video source generates a sequence of serial data which represents at least a part of the image. A memory includes an array of memory cells arranged in rows and N columns with each memory cell being assigned a row and a column address. A data register which interconnects with the data processor, the video source, and the array of memory cells has N/2 storage elements. The data register responds to the control signals and to the serial sequence of data received from the video source for storing the data in the data register. Subsequently in response to memory addresses and further control signals, that data is written in parallel to an addressed row and selectively to memory cells within either a low-half of the column addresses or a high-half of the column addresses of the array of memory cells.

The display system is further arranged for reading the data from the array of memory cells in parallel to the data register which sends that data in serial sequence for conversion to a video signal to produce and display the desired image on a display device.

A video random access memory chip used within the system includes an array of memory cells arranged along rows and N columns, both the rows and the columns have distinct addresses. The rows of the memory cells are split into low-half addresses and high-half addresses. A data register includes only N/2 storage elements for storing a serial sequence of data. N transfer gates are located between the data register and the columns of cells of the array for selectively connecting the storage elements of the data register either to the low-half of the column addresses or to the high-half of the column addresses. A part of each column address applied to the memory is stored in an auxiliary address register. In response to the stored part of the column address and a transfer clock signal, a circuit generates a write transfer signal that controls the writing of stored data from the N/2 storage elements of the data register selectively through N/2 of the transfer gates either to the low-half column addresses or to the high-half column addresses.

An advantage of the disclosed arrangement is that one-half of the data register storage elements formerly used in prior art video random access memories are no longer needed on the video random access memory chip. A proportionate area of semiconductor chip can be eliminated to reduce chip area and cost.

The aforementioned reduction in the chip area and cost are accomplished without increasing system complexity and cost. Only minor changes in system operations are required to design an operable graphics display system. These changes can be provided by changes in system software rather than in system hardware.

## Brief Description of Drawing

A better understanding of the invention may be derived by reading the following detailed description with reference to the drawing wherein;

Figure 1 is a block diagram of a graphics display system;

Figure 2 is an illustration of the layout of a prior art video random access memory integrated circuit chip;

Figure 3 is a layout of a video random access memory integrated circuit chip incorporating the features of an illustrative embodiment of the invention;

Figures 4 and 5 when put together as shown in Figure 6 present a block diagram of an illustrative video random access memory;

Figure 7 is a partial block diagram of a graphics display system;

Figure 8 is a diagram of the logic circuit arrangement for transferring data between the half length serial register and the cells of the memory array; and

Figure 9 presents a timing diagram for writing data from the serial register to the memory array.

## Detailed Description

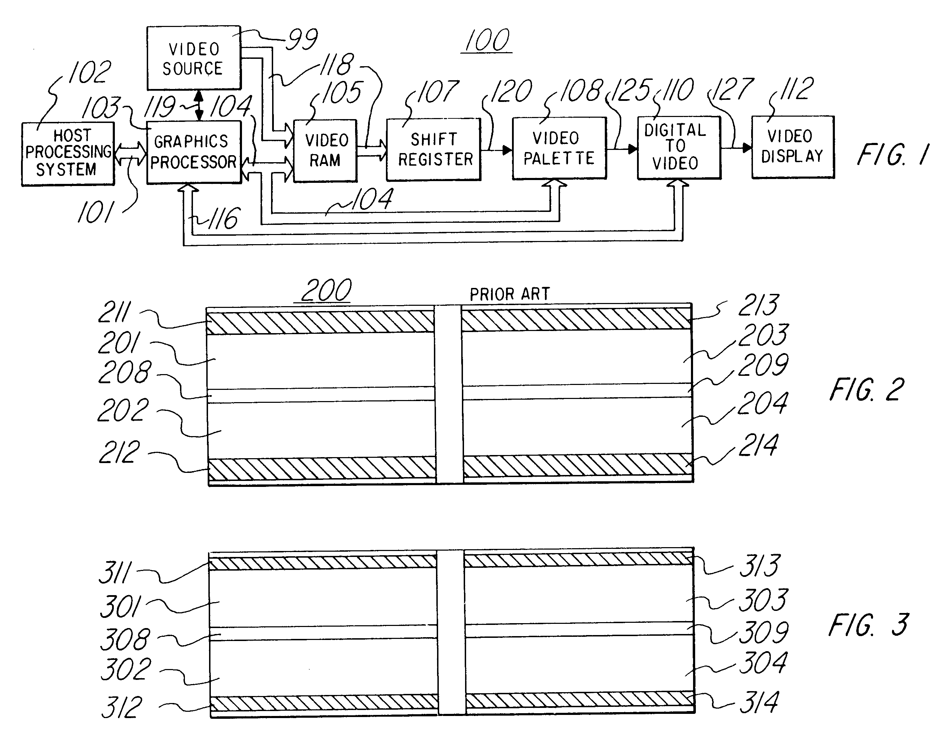

Referring now to Figure 1, there is shown a block diagram of a data processing system 100 including a graphics display arrangement for presenting information. A more complete description of the arrangement and operation of the system of Figure 1 can be found in a patent application serial No. 346,388, filed April 27, 1989 (Attorney's Docket No. TI0984B). The aforementioned patent application is hereby incorporated herein by reference.

The data processing system 100 includes a host processing system 102, a graphics processor 103, a video source 99, a video random access memory 105, a shift register 107, a video palette 108, a digital to video converter 110, and a video display 112.

Host processing system 102 provides the major computational capacity for the data processing system 100. Included in the host processing system 102 are a processor, an input device, a long term storage device, a read only memory, a random access memory and assorted peripheral devices that form a complete computer system. Arrangement and operation of the host processing system are considered to be conventional. As a result of its processing functions, the host processing system 102 controls the content of the desired graphic image to be presented on a screen for the user.

The video source 99 generates a sequence of serial data that is related to the desired image and is applied by way of a video data bus 118 to the video random access memory 105. Control signals for coordinating data transfers, either from the video source 99 or from the graphics processor 103 to the video random access memory 105, are carried by leads 119.

Graphics processor 103 provides the major data manipulation for producing the desired graphic image information to be presented on the screen. The graphics processor 103 is bi-directionally coupled to the host processing system 102 by way of a host bus 101. In the arrangement of Figure 1, graphics processor 103 operates independently from the host processing system 102. The graphics processor 103, however, is responsive to requests from the host processing system 102. Graphics processor 103 also communicates with the video random access memory 105 and the video palette 108 by way of a bi-directional memory bus 104. Data to be stored in the random access memory 105 is controlled by the graphics processor 103. The graphics processor, in turn, may be controlled either in part or wholly by a program stored in the random access memory or in the read only memory. Read only memory may store various types of graphic image data. The graphics processor 103 can retrieve such graphic image data from either the video random access memory 105 or the read only memory, manipulate that data, and store the result in the video random access memory 105.

Additionally the graphics processor 103 controls data stored within the video palette 108 and by way of a video control bus 116 the operation of the digital to video converter 110. Further, the graphics processor 103 can control the line length, the number of lines per frame of the video image by control of the digital to video converter 110 through the video control bus 116.

Significantly, the graphics processor determines and controls where graphic display information is stored in the video random access memory 105 regardless of whether the information is transmitted to the memory in parallel format or in a serial sequence. Subsequently, during serial readout from the video random access memory 105, the graphics processor determines the readout sequence, the addresses from which data is read out, and the control information required to produce the desired graphic image on the display 112.

Random access memory 105 stores bit mapped data which represents the desired image to be presented to the user. Control of the presentation of the data, from the random access memory 105 through the shift register 107, the video palette 108, and the digital-to-video converter 110 to the video display 112, is provided by the graphics processor 103. Video data output from the random access memory 105 is transmitted by way of a video data bus 118 to the shift register 107 where it is assembled into a display bit stream.

In accordance with a typical arrangement of the random access memory 105, there is a bank of several separate random access memory arrays. During a serial readout operation, the bits of information are read out sequentially in a serial bit stream from each memory array. The several separate memory arrays are arranged so that a bit is read out concurrently from each of them. The shift register 107 interleaves the bits of the plural bit streams into a display bit stream for transmission by way of a bus 120 to the video palette 108.

Under control of information from the graphics processor 103, the video palette 108 converts the data received from the shift register 107 into digital video signals on a bus 125. This conversion is accomplished through a look-up table. The digital video signal output from the video palette 108 may include color, saturation, and brightness information.

Digital-to-video converter 110 receives the digital video information from the video palette 108 and, under control of signals received by way of the video control bus 116, converts the digital information into analog video signals which are applied to the video display 112 via an output video signal line 127. The number of pixels per horizontal line and the number of lines per frame of the display are determined by the graphics processor 103. Also, the synchronization, retrace, and blanking signals are controlled by the graphics processor 103. Altogether, such control signals specify the content of the desired video signal which is sent to the display 112.

Video display 112 processes the desired video image for viewing by the user. There are two techniques which are used widely. The first technique specifies video data in terms of hue and saturation for each pixel. For the second technique, color levels of red, blue and green are specified for each pixel. The video palette 108, the digital-to-video converter 110 and the video display must be designed and fabricated to be compatible with the selected technique.

Referring now to Figure 2, there is shown a sketch of the outline of a layout of a metal oxide semiconductor (MOS) chip designed as a prior art video random access memory 200. The memory 200 includes four arrays of memory cells 201, 202, 203, and 204. Associated with the arrays are groups of sense amplifiers 208 and 209, which are used for reading data bits from the memory cells by way of bit lines coupling columns of the memory cells to the sense amplifiers 208 and 209. Also associated with each array of memory cells, there are a data register and a group of transfer gates for selectively coupling the data from a row of the memory cells to the data register. Data registers and transfer gates 211, 212, 213, and 214, respectively, are associated with the arrays 201, 202, 203, and 204. The represented data registers include one storage element for each column of memory cells in the associated array of memory cells, as used in prior art arrangements.

Referring now to Figure 3, there is shown a sketch of the outline of a layout of a MOS chip, representing a video random access memory incorporating an illustrative embodiment of the invention. There are four arrays of memory cells 301, 302, 303, and 304 with groups of sense amplifiers 308 and 309. In each array of Figure 3, the number of memory cells per row, i.e., the number of columns of memory cells, is the same as in Figure 2. Data registers and transfer gates 311, 312, 313, and 314 are associated, respectively, with the arrays 301, 302, 303, and 304.

It is noted that the data registers and groups of transfer gates cover substantially less area in the layout of Figure 3 than in the layout of Figure 2. The reduction in area arises because each data register of Figure 3 includes one-half of the number of storage elements used in each data register of Figure 2. The columns of the memory cells are split by address into low-half addresses and high-half addresses. Each data register includes only half as many storage elements as there are columns of memory cells in its associated memory array. This reduction of the number of storage elements in the data registers, with respect to the arrangement of the prior art, results in a commensurate reduction in the MOS chip area and cost, as shown in Figure 3.

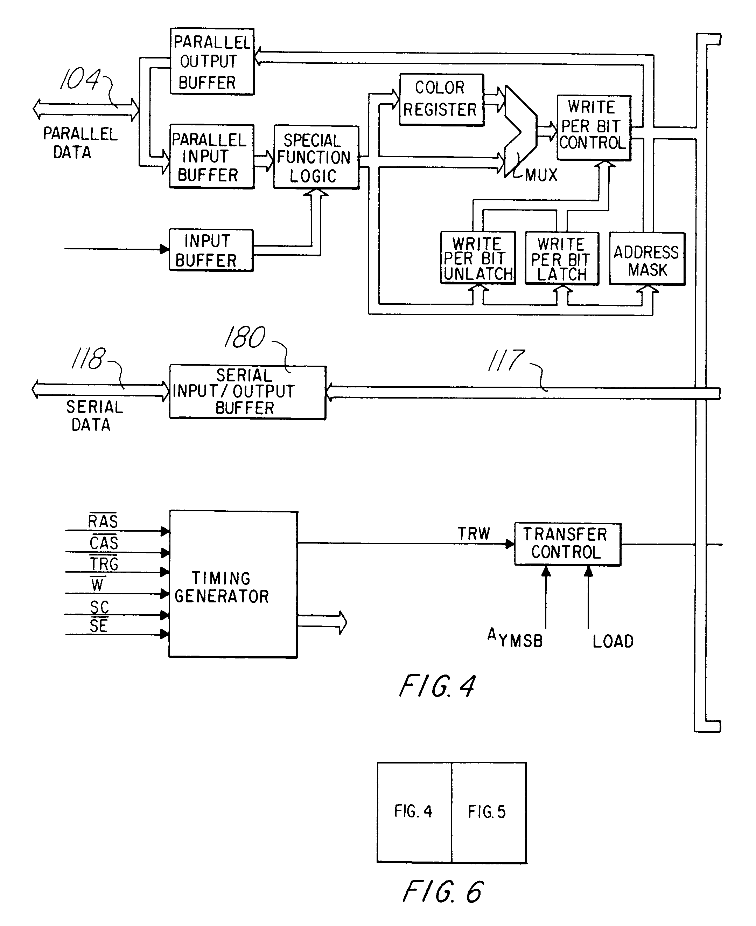

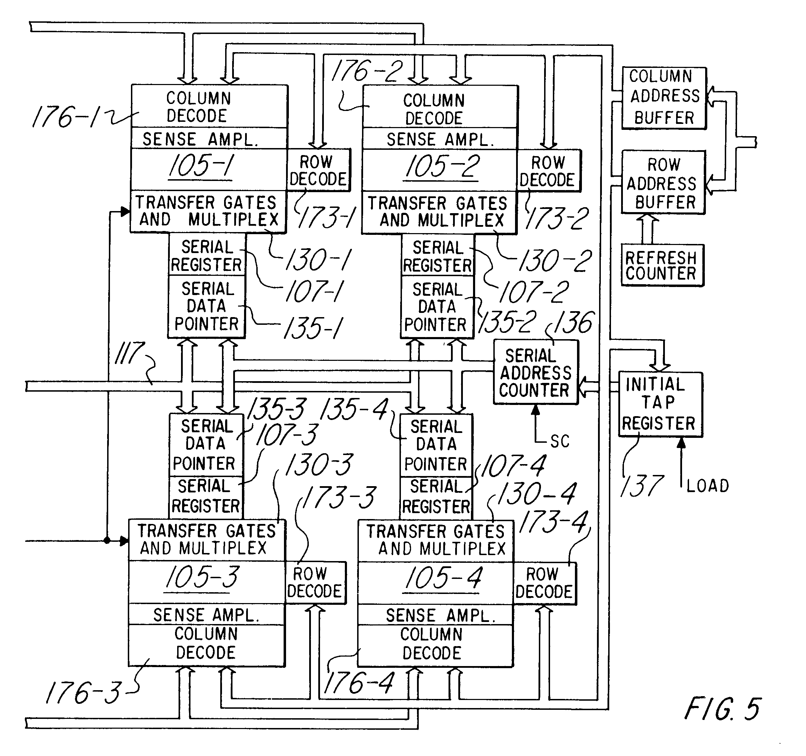

Referring now to Figures 4 and 5, there is shown an illustrative block diagram of a video random access memory in accordance with the invention, made as an integrated circuit chip. Circuits on the chip are arranged for write-in and readout of data over a parallel data input/output bus 104. Data is stored in four arrays of memory cells 105-1, 105-2, 105-3, and 105-4 arranged in rows and columns which are accessed by addresses applied to row decoders 173-1, 173-2, 173-3, 173-4, and column decoders 176-1, 176-2, 176-3, and 176-4. Other circuits on the chip are arranged for serial write-in and readout of data by way of a serial data input/output bus 118, a serial input/output buffer 180, and a data bus 117.

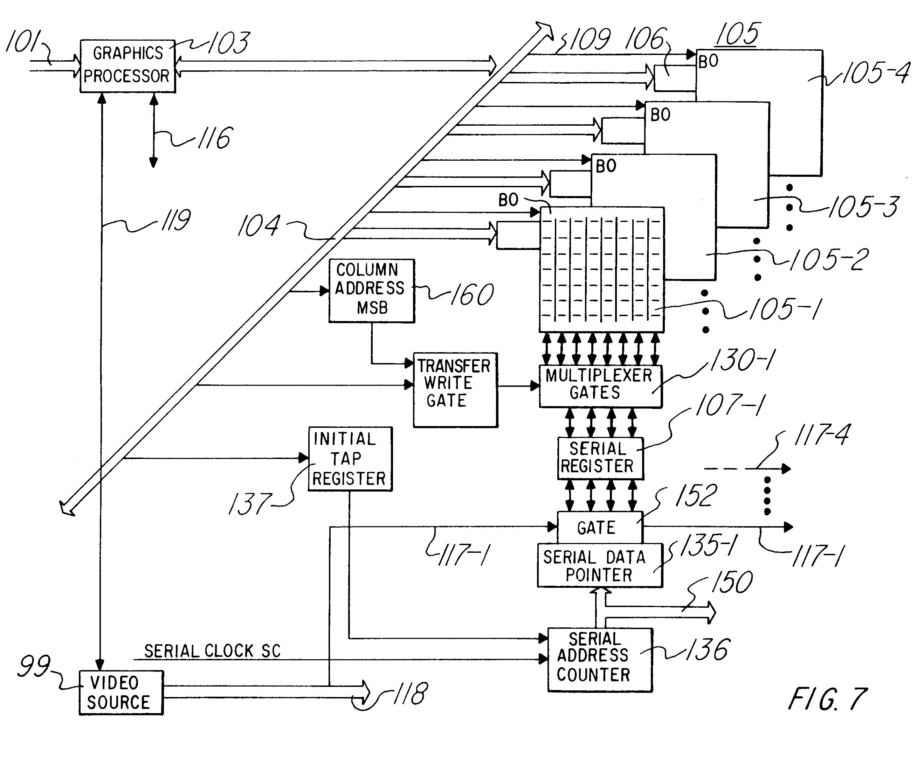

Referring now to Figure 7, there is shown a partial block diagram of the graphics processor 103, video random access memory 105, a serial register 107-1, some of the control circuitry, and interconnecting busses and leads. Video random access memory 105 is an exemplary memory including the four memory arrays 105-1, 105-2, 105-3, and 105-4 having rows and columns of storage elements. Information representing a single pixel for the display may include several bits of information.

Although the four video random access memory arrays 105-1, 105-2, 105-3, and 105-4 are shown ganged together in Figure 4, only one of them, 105-1, will be discussed hereinafter for purposes of simplifying both the drawing and the description without compromising any generality. It is to be understood that what is shown and said about the one memory array and associated circuitry applies to the other memory arrays which are ganged together from one or more semiconductor chips.

The screen of the video display 112 of Figure 1 can be organized as a large number of horizontal lines each including a large number of pixels. Row and column address information is generated by the graphics processor 103. Desired display, or pixel information, is generated either by the graphics processor 103 or the video source 99.

For random access writing, the addresses are applied through the bus 104 to an address register 106 for accessing the identified row and column storage locations in the random access memory array 105-1. The display data, to be stored at each address, also is applied through the bus 104 and a lead 109 to the random access memory array 105-1. When the graphics processor develops the random access address and display data, that data is transmitted through bus 104 and is written into the random access memory 105-1 by making a row access and thereafter accessing a selected column where information is to be stored.

For writing serially into the memory array 105-1 from the video source 99, another arrangement and operation is utilized. First of all, the graphics processor sends an initial tap address into an initial tap address register 137 and a serial address counter 136. This initial tap address thereafter is transferred into a serial data pointer 135-1 where it points to a tap in a multiple gate 152 through which the initial bit of the sequence of data is to be stored into a storage element of the serial register 107-1. Thereafter serial clock pulses SC increment the count contained in the serial address counter 136. The serial sequence of data is generated by the video source 99, is transmitted through the video data bus 117-1 to the multiple gate 152, which includes individual taps to each storage element of the serial register 107-1. During the counting, the sequence of data is stored into a sequence of storage elements of the serial register 107-1.

Meanwhile when the entire sequence of data is stored in the serial register 107-1, that data can be written in parallel into storage in a selected half row of the memory array 105-1. Because the serial register 107-1 is only half of the length, i.e., in the number of cells, the multiplexer 130-1 includes gates so that the sequence of data stored in the serial register 107-1 can be stored either in the high-half addresses or the low-half addresses of the selected row of the memory array 105-1.

The write-in circuitry requires, in advance, a determination of whether the data will be written into the high-half addresses or the low-half addresses of the memory array. In Figure 7, there is a column address most significant bit register 160, which receives and stores the most significant bit during an address time slot preceding the time slot during which the data is to be transferred from the serial register into the memory array. Thus when using the half length serial register for a transfer write operation, the most significant column address bit $A_{YMSB}$ is provided by the processor in the transfer cycle before the transfer write operation is to be executed. The row address is provided in the transfer cycle when the write operation is to be executed. The most significant column address bit is provided during the prior transfer cycle to facilitate the transfer operation. It identifies which half of the memory columns are to be written. The remaining bits of the column address identify the initial top for writing into the half length serial register.

As a result, the entire arrangement with the half length serial register is compatible with other systems which use a full length serial register (whether or not it is split). The user must use twice the number of transfer writes to complete a specific sequence of data.

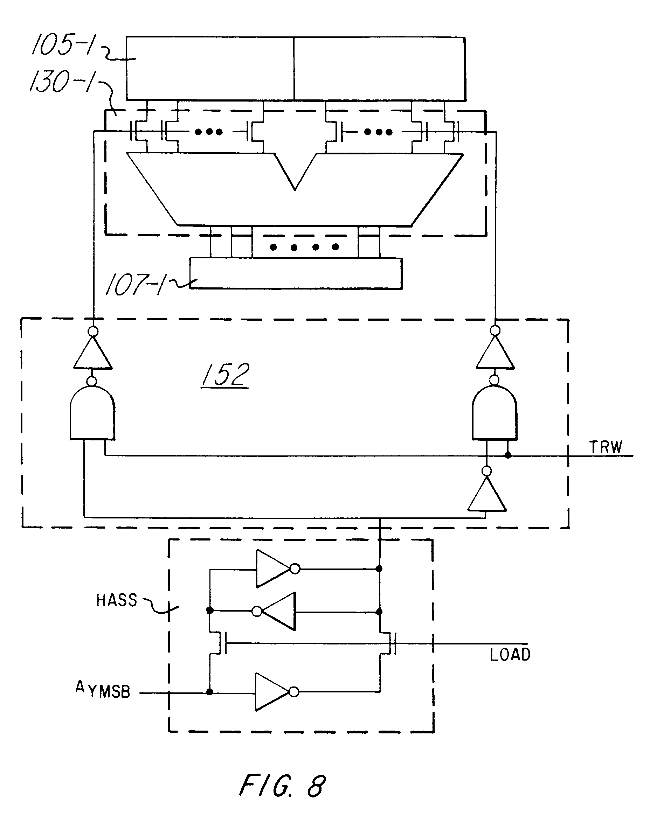

Referring now to Figure 8, there is shown a circuit arrangement for storing the most significant bit of the column address and for subsequently transferring data from the serial register to the selected half of the memory array. First of all, in anticipation of a serial write operation, the most significant bit of the column address is generated by the graphics processor 103 and is applied through the bus 104 to a column address half array selection store HASS for a system wherein the serial register includes only half as many storage elements as the number of memory cells in a row of the memory array 105-1. The most significant bit $A_{YMSB}$ of the column address is latched into the half array selection store HASS to commence the serial write operation. The remaining bits of the column address are latched into the initial tap address register 137 of Figure 7. From the initial tap address register 137, the partial column address stored therein is applied to and is stored in the serial address counter 136 for determining which tap of the serial register 107-1 is first pointed to for writing in a bit of data. Subsequent bits of data are stored in a sequence of storage elements of the serial register 107-1. The data bits, generated by the video source 99, are applied in serial sequence through a lead 117-1 to a gate 152, which is operable in response to the initial tap address for storing the first bit of the sequence into the storage element associated with the initial tap address of the serial register 107-1. Subsequent bits of the serial sequence are stored in sequential ones of the storage elements of the serial register 107-1, as the counter decoder is incremented by the serial signal CLOCK.

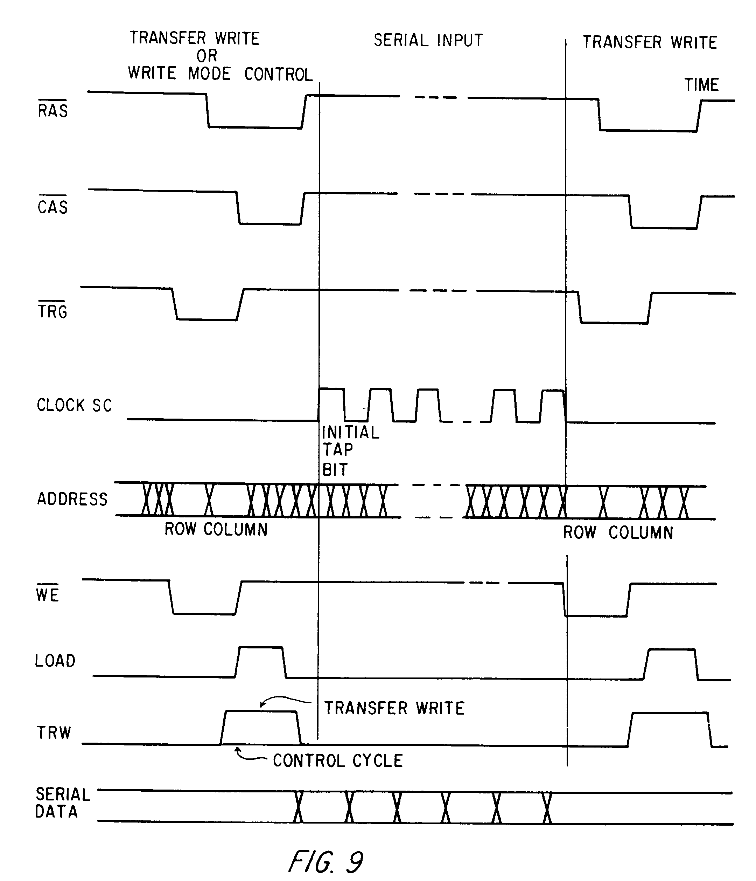

Details of the operation can be understood by following the subsequent description of the operation with reference to Figure 9.

In Figure 9, there are shown waveforms for nine different signals used for controlling write-in of data to the memory array 105-1. Row access strobe signal (complemented) RAS is a clock for timing access to any selected row of the memory array 105-1. Column access strobe signal (complemented) CAS is a clock for timing any access to any selected column of the memory array 105-1 and for timing the availability of address information for serial read or write operations. Transfer control signal (complemented) TRG is a clock for timing any transfer of information between the memory array 105-1 and the serial register 107-1 for either write-in or readout. A serial clock signal CLOCK shows that no serial write-in occurs until row and column addressing are complete. Column address data are latched into the initial tap register and the half array selection store HASS during the write mode control cycle or a transfer write cycle by the signal LOAD. Thereafter the first bit of a serial write-in of a sequence of data bits is applied through the lead 150 and the gate 152 to the storage element associated with the selected initial tap of the serial register 107-1. Subsequent bits of the sequence are stored in sequential ones of the storage elements. Random access write and read operations can occur while the serial write operation continues. The random access and serial write operations are isolated from each other.

Once the entire data sequence is stored in the serial register 107-1, that data can be written in parallel to a half row of the memory cells of the memory array 105-1. The data stored in the half array selection store HASS and continuously applied to the transfer write gate is clocked through that gate by the transfer write signal TRW. The transfer write gate applies a transfer device enabling signal alternatively to one or the other of the two groups of transfer devices. This enables the data stored in the half length serial register 107-1 to be written into the selected row of one half the memory array 105-1.

The memory array 105-1 is divided by address into a low-half and a high-half. Such division greatly facilitates readout from the memory array 105-1 to the video display 112 of Figure 1. Readout from the memory array 105-1 can occur sequentially by line of the display. As the raster scans a line of the display, the appropriate information for each pixel in sequence is applied to the beam for projection on the display screen. The graphics processor 103 determines the order for addressing the memory cells of the memory array 105-1, the selection made by the multiplexer 130-1, and the order for reading information from the storage elements of the serial register 107-1 to achieve the desired output sequence of information being forwarded to the video display 112.

Rows of the memory are addressed by half rows, i.e., low address half rows and high address half rows. Under control of the graphics processor 103, a multiplexer 130-1 determines whether the information read out of either the low-half or the high-half of the memory array is transmitted to the half length serial register 107-1. Once the information is stored in the serial register 107-1, one or more bits of data can be transmitted out to the video display 112.

Additional control circuitry, which is common to the several memory arrays, is provided for determining the specific portion of information to be transmitted from the serial register 107-1. The data from the serial register 107-1 can be read out from a separate tap at each storage element. Conceptually, the taps are represented by the gate circuit 152 which receives a separate output from each storage element of the serial register 107-1. The serial data pointer 135 determines which one of the serial register storage element outputs is transmitted to the video display 112 during any time slot determined by a readout clock signal CLOCK.

Since the initial pixel information to be transmitted may be in any serial register 107-1 location, the graphics processor 103 loads the address of that initial pixel information into the initial tap register 137. Upon receipt of a reset signal from the comparator 145, the initial tap register 137 loads the initial pixel data address into the serial address counter 136 for generating the serial data pointer which is put into the serial data pointer 135-1 for enabling the gate circuit 152 to transmit the information from the correct initial serial register storage element. Loading of the initial pixel data address may be in parallel to the serial data pointer 135-1.

Information read out thereafter generally proceeds sequentially along the storage elements of the serial register 107-1. A sequence of addresses is produced by the serial address counter which is incremented by the serial clock signal SC. These addresses are applied to the serial data pointer 135-1 which determines which tap is to be accessed during each clock cycle commencing with the initial tap address. The sequence of addresses continues as the serial address counter is incremented by the signal CLOCK for each readout operation. When the sequence is finished, a new initial tap address can be loaded into the initial tap register 137. The serial data pointer 135-1 enables the gate circuit 132 to jump to that new initial tap address of the serial register 107-1.

Figure 8 additionally illustrates a schematic for the multiplexer 130-1 which can be used for reading out information from either half of the memory array 105-1 to the half length serial register 107-1. The illustrated multiplexer 130-1 couples each column of the high half or each column of the lower half of the memory array to the associated storage elements of the serial register.

Generally, in a graphic display system, the sequential order of readout of information from memory is fixed by the harware and firmware of the entire display system. There may be some options in the hardware or firmware which alter the sequential order of readout, e.g., reversing the sequential order of readout to invert the graphic display.

The graphics processor 103 and video source 99 of Figures 1 and 7 generate all of the information for the graphic display. Each bit of the information can be generated at any time and in any order. The processor 103 knows which bit is being generated at any time and where that bit must be stored in the random access memory 105. When writing the bits into the random access memory, the order of writing the bits is unimportant. What is important is that each bit is to be stored in a storage element at a predetermined location in the random access memory.

After a complete screen of information is stored in the random access memory 105-1, the system can commence reading information from the random access memory for transfer through the serial register 107-1 to the video display 112. Such video display uses a well-known raster scanning technique for presenting information on a screen or cathode ray tube. Meanwhile, the graphics processor 103 scans the random access memory for reading out information to the display. Information from the memory array is coordinated with the raster beam as it sweeps across one horizontal line projecting the graphics information to be displayed onto the screen at predetermined locations. While the serial register 107-1 is being read out to the display 112, another half row of information can be transferred from the memory array to the serial register 107-1. At the finish of each line, the raster retraces, or returns, to the beginning side of the screen, one or more lines lower. During retrace, information is blanked from the beam. Once the retrace is completed, the raster commences sweeping across another line of the screen. Because the raster beam sweeps across the entire screen before retracing, the information read from the memory array must be presented to the beam modulator of the video display 112 in the proper sequential order.

The foregoing description presents the arrangement and operation of an illustrative example of the invention. This exemplary example and other arrangements, made obvious in view thereof, are considered to be within the scope of the appended claims.

## Claims

1. An image display system comprising
    a data processor for generating data representing at least part of an image, memory addresses for the data, and control signals for the system;

a video source for generating data in a serial sequence representing at least part of the image;

a memory including an array of memory cells arranged in rows and N columns, each memory cell being assigned a row and a column address; and

a data register, interconnected with the data processor, the video source, and the data storage array and having N/2 storage elements, the data register, responsive to the memory addresses, to the control signals and to the data in the serial sequence from the video source, for receiving the data and for writing the data in parallel to an addressed row and selectively to memory cells having either a low-half of the column addresses or a high-half of the column addresses.

2. An image display system, in accordance with claim 1, further comprising

a display device arranged for receiving the data from the data storage array; and

the data register being interconnected with the display device and responsive to control signals from the data processor for receiving data read out in parallel from a row of the memory array selectively from either the low-half of the column addresses or the high-half of the column addresses and for sending the data to the display device.

3. An image display system, in accordance with claim 2, wherein;

the data register is a serial register.

4. A video random access memory chip comprising;

an array of memory cells arranged in rows and N columns, each row and column having a distinct address, the rows of memory cells being split into a group of low-half column addresses and a group of high-half column addresses,

a data register including only N/2 storage elements for storing a sequence of data;

N transfer gates interposed between the N/2 storage elements of the data register and the N columns of the array, a first group of N/2 transfer gates for coupling each of the N/2 storage elements of the data register separately to a different column of the low-half of the column addresses and a second group of N/2 transfer gates for coupling each of the N/2 storage elements of the data register separately to a different column of the high-half of the column addresses;

an auxiliary address register for storing a part of each column address; and

a circuit, responsive to a part of a first column address and a transfer clock signal, for producing a write transfer signal that controls writing data from the N/2 storage elements of the data register selectively through either the first N/2 transfer gates or the second N/2 transfer gates to the memory cells either of the low-half column addresses or of the high-half column addresses of a row in the array.

5. A video random access memory chip, in accordance with claim 4, wherein;

the data register is responsive to control signals and received serial data for storing the received serial data; and

the data register and the array of memory cells are responsive to a part of a second column address, to control signals, and to a row address received from the data processor for transferring to the register the data stored in the memory cells either of the low-half of the column addresses or the high-half of the column addresses in the addressed row in the array.

6. A video random access memory chip, in accordance with claim 5, wherein;

the data register is a serial register;

the part of the first column address is the most significant bit of the first column address; and

the part of the second column address is the most significant bit of the second column address.

7. An image display system comprising;

a data processor for generating data represeting at least a part of an image, memory addresses for the data, and control signals for the system;

a video source for producing a serial sequence of data representing at least a part of the image;

a data storage array having memory cells arranged in rows and columns; and

a serial register, interconnected with the data processor and the data storage array and having only one-half the number of storage elements as the number of memory cells in a row of the data storage array, the serial register arranged for receiving the data from the video source in the serial sequence and transferring the data selectively to either a low-half of row addresses or a high-half of row addresses of the data storage array.

8. An image display system, in accordance with claim 7, further comprising;

a display device for receiving data from the data storage array; and

the serial register being interconnected with the display device and responsive to control signals from the data processor for receiving data selectively from either the low-half row addresses or the high-half row addresses and sending the data received from the data storage array.

9. A video random access memory chip comprising;

an array of memory cells arranged in rows and N columns, the rows of storage cells being split into low-half column addresses and high-half column addresses,

a serial register including only N/2 storage elements for storing a sequence of data;

N transfer gates interposed between the storage elements of the serial register and the N columns of the array, a first N/2 transfer gates for coupling the storage elements of the serial register to the low-half column addresses and a second N/2 transfer gates for coupling the storage elements of the serial register to the high-half column addresses;

a register for storing a part of a column address; and

a circuit, responsive to the part of the column address and a transfer clock signal, for producing a write transfer signal that controls writing data from the storage elements of the serial register through either the first N/2 transfer gates or the second N/2 transfer gates to N/2 of the memory cells of the array.

FIG. 1

FIG. 2

PRIOR ART

FIG. 3

FIG. 4

FIG. 6

| FIG. 4 | FIG. 5 |
|--------|--------|

FIG. 5

FIG. 7

EP 0 474 435 A2

FIG. 8

FIG. 9